# EUROPEAN PATENT SPECIFICATION

(11) **EP 3 242 340 B1**
(45) Date of publication and mention of the grant of the patent: **24.05.2023**
(21) Application number: 16172226.9
(22) Date of filing: 31.05.2016
(51) Int. Cl.: H01L 51/42, H01L 27/30

(54) **SOLAR CELL**
SOLARZELLE
CELLULE SOLAIRE

(30) Priority: 04.05.2016 EP 16168403
(43) Date of publication of application: 08.11.2017
(73) Proprietor: Novaled GmbH, 01099 Dresden (DE)
(72) Inventor: Momblona Rincon, Maria Cristina, 46010 Valencia (ES); Escrig, Lidon Gil, 12132 Atzeneta del Maestrat, Castellon (ES); Sessolo, Michele, 46020 Valencia (ES); Bolink, Jan Hendrik, 46116 Moncada (ES); Blochwitz-Nimoth, Jan, 01097 Dresden (DE); Lederer, Kay, 01109 Dresden (DE)
(74) Representative: Bittner, Thomas L.

(56) References cited:
- EP-A2- 2 942 826
- WO-A1-2012/175219
- LAUREN E. POLANDER ET AL: "Hole-transport material variation in fully vacuum deposited perovskite solar cells", APL MATERIALS, vol. 2, no. 8, 14 July 2014 (2014-07-14), page 081503, XP055315493, DOI: 10.1063/1.4889843

## Description

The present disclosure relates to a solar cell.

### Background

Thin-film photovoltaic is a key technology among future low cost and sustainable renewable energy sources. Organic-inorganic (hybrid) lead halide perovskite solar cells have been proposed for photovoltaic applications because of their impressive power conversion efficiencies (PCEs), now exceeding 21%. (see Kojima et al., J. Am. Chem. Soc. 131, 6050-6051 (2009); Lee et al., Science 338, 643-647 (2012); Yang et al., Science 348, 1234-1237 (2015)).The perovskite thin-film absorber can be deposited by simple solution or sublimation methods, hence with a large potential for the preparation of inexpensive photovoltaic devices. The high PCEs are the result of the very high absorption coefficient and mobilities of the photogenerated electrons and holes of hybrid perovskites.

In order to prepare high performance solar cells, homogeneous perovskite films with a high degree of crystallinity are needed in order to reduce the trap concentration and achieve an adequate mobility of the charge carriers (see Nie et al., Science 347, 522-525 (2015)). While the use of the archetype perovskite, methylammonium lead iodide (MAPbI₃), can lead to high efficiency devices, a further decrease of the bandgap by incorporation of formamidinium (FA), allows for the harvesting of additional near-infrared photons (see Pellet et al., Angewandte Chemie International Edition 53, 3151-3157 (2014)).When such a mixed organic cation perovskite is further stabilized by replacing part of the iodide with bromide, the champion material for perovskite cells, (FAPbI₃)₁₋ₓ(MAPbBr₃)ₓ, is obtained (see Yang et al., Science 348, 1234-1237 (2015); Jeon et al., Nature 517, 476-480 (2015); Bi et al., Science Advances 2 (2016)).

Different solar cell architectures have been used. One of them derives from dye-sensitized solar cells, and consists of a transparent conductive substrate coated with a mesoporous or planar TiO₂ layer (n-type, hence acting as the electron transport layer, ETL) into or onto which the perovskite light absorbing layer is applied. A hole transport layer (HTL, p-type), usually consisting of organic semiconductors is then deposited from solution on top of the perovskite and the device is finished with an evaporated top electrode (see Stranks et al., Science 342, 341-344 (2013); Eperon et al., Advanced Functional Materials 24, 151-157 (2014); Conings et al., Advanced Materials 26, 2041-2046 (2014); and Chen et al., Journal of the American Chemical Society 136, 622-625 (2014)).

Another configuration is inverted compared to the above mentioned one, and the conductive substrate is coated with a HTL, followed by the perovskite absorber and an ETL, coated with a suitable evaporated top electrode (see Wu et al., Energy & Environmental Science 8, 2725-2733 (2015); Zhou et al., Science 345, 542-546 (2014). While these two device configuration have been identified as "conventional" and "inverted", such devices may rather be referred to as n-i-p device and p-i-n device. A detailed explanation of n-i-p and p-i-n devices will be provided in the summary.

Chen et al. (Science 350, 944-948 (2015)) demonstrated that the PCE in planar devices may be limited by the conductivity of the metal oxide layers, which can be increased by doping these layers. This was achieved by incorporating heteroatoms with different valences into the solution processed metal oxides, although leading only to a small increase in the conductivity (approximately one order of magnitude). Thus, only very thin metal oxide transport layers (<20 nm) could be used otherwise PCE would drop significantly. We propose a more versatile strategy to control the conductivity of charge transport layers in perovskite devices is the use of doped organic semiconductors. These materials are used in organic light-emitting diodes and also in small molecular weight organic solar cells.

In doped organic semiconductors the conductivity can be varied over several orders of magnitude by increasing the doping concentration. However, it is unknown as of yet, if the incorporation of such doped layers would yield enough charge carrier transport for perovskite solar cells without conflicting with other key PV parameters such as PCE, FF, Voc and lifetime, hence degrading overall performance. Contrary to an OLED (organic light emitting diodes) no external voltage is applied, and contrary to the case in organic photovoltaic devices (which typically use thinner absorption layers and several absorber units connected in series) the current density is larger.

Most reported organic-inorganic (hybrid) lead halide perovskite solar cells that are employing a vacuum deposited perovskite light absorbing layer do then employ charge transport layers processed from solution. Fully vacuum processed solar cell devices would offer the additional advantage of being compatible with temperature sensitive substrates, allowing for conformal coatings on non-planar substrates and for the straightforward implementation into tandem solar cells (see Polander et al., APL Materials 2, 081503 (2014)). Besides the high sophistication level of the deposition systems required for vacuum processing, they have been implemented in the electronic industry since long demonstrating high throughput and reliability (Ono et al., Journal of Materials Chemistry A (2016)).

By selecting certain hole transport molecules with regard to the energy levels of the conduction and valence band of the perovskite, open circuit voltages (Voc) as high as 1.1 V were demonstrated (Polander et al., APL Materials 2, 081503 (2014); Kim et al., Organic Electronics 17, 102-106 (2015), Ono et al., Journal of Materials Chemistry A (2016)). The highest efficiency (15.4%) was measured for a device with rather high hysteresis (14.0 % PCE was obtained for the same cell measured in the opposite bias scan direction), which used single layers of undoped organic molecules as the charge extraction layers (see Ke et al., Journal of Materials Chemistry A 3, 23888-23894 (2015)). This is in line with the conclusions of Berhe et al., Energy Environ. Sci., 2016, 9, 323-356 that high stability and lifetime of perovskite solar cells can rather be achieved with solution processed perovskite absorbers.

Electrically doped perovskite layers and their use as light absorbing and / or charge transport layers in optoelectronic devices is disclosed in document EP 2 942 826 A2.

Polander et al., APL Materials 2, 081503 (2014) furthermore addresses the effect of energy level alignment between the hole-transporting material and the active layer in vacuum deposited, planar-heterojunction CH₃NH₃PbIₓ₋₃Clₓ perovskite solar cells. Through a series of hole-transport materials, with conductivity values set using controlled p-doping of the layer, their ionization potentials are correlated with the open-circuit voltage of the device. With ionization potentials beyond 5.3 eV, a substantial decrease in both current density and voltage is observed, which highlights the delicate energetic balance between driving force for hole-extraction and maximizing the photovoltage. When an optimal ionization potential match is found, the open-circuit voltage can be maximized, leading to PCE values of up to 10.9 %. The values are obtained with hole-transport materials that differ from the commonly used Spiro-MeO-TAD and correspond to a relative 40% performance increase.

Document WO 2012/175219 relates to an electronic device comprising a compound according to the formula
A-B, wherein 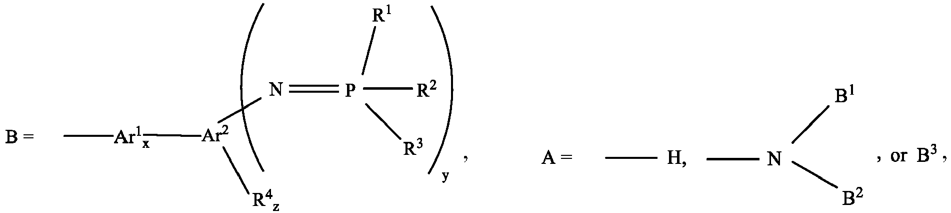 and wherein
- Ar¹ is a C6-C18 arylene, which can be monocyclic or polycyclic and may be optionally substituted by one or more C₁-C₁₀-alkyl or C₃-C₁₀-cycloalkyl groups,
- Ar² is a C6-C18 arene skeleton, optionally substituted with electron donating groups R⁴,
- B¹ and B² are independently selected from B and Ar²,
- B³ is independently selected from the same group as B
- R¹, R², R³ are independently selected from alkyl, arylalkyl, cycloalkyl, aryl, dialkylamino,
- x is selected from 0, 1, 2 and 3, wherein for x > 1 each Ar¹ may be different,
- y is a non-zero integer up to the overall count of valence sites on the arene skeleton,
- z is a integer from zero up to the overall count of valence sites on the arene skeleton minus y;
as well as a respective compound according to formula A-B.

State of the art solar cells may suffer from low open-circuit voltage, low short-circuit current, low efficiency, short lifetime and/ or low fill factor.

### Summary

It is an object of the present disclosure to provide a solar cell which overcomes drawbacks of the prior art. In particular, it is an object to provide a solar cell having improved open-circuit voltage, short-circuit current, efficiency, lifetime and/ or high fill factor.

A solar cell according to claim 1 is provided. Alternative embodiments are disclosed in the dependent claims.

A solar cell comprises a first electrode and a second electrode and at least one stack of layers provided between the first electrode and the second electrode. The at least one stack of layers comprises a first light absorbing layer provided with a layer thickness of about 200 nm to about 700 nm, and comprises an absorber compound provided with a perovskite crystal structure.

The first organic p-type layer may consist of at least one of a layer consisting of an organic p-type dopant; and a layer consisting of a mixture of an organic p-type dopant and a first organic aromatic matrix compound.

The first n-type layer may consist of at least one of a layer consisting of an n-type dopant; and a layer consisting of a mixture of an n-type dopant and a second organic aromatic matrix compound.

In an embodiment the first organic p-type layer is in direct contact with the first electrode and with the first light absorbing layer. Thereby, good performance is achieved.

The first organic aromatic matrix compound has a molecular weight of 400 to 1500. The organic p-type dopant has a molecular weight of 350 to 1700.

In an embodiment the first organic aromatic matrix compound has a molecular weight of 500 to 1300.

In another embodiment the organic p-type dopant has a molecular weight of 350 to 800.

If the molecular weight is in this rage, suitable evaporation rate may be achieved during vacuum thermal deposition.

The first oxidation potential of the first organic aromatic matrix compound is equal to or less negative compared to N2,N2,N2',N2',N7,N7,N7',N7'-octakis(4-methoxyphenyl)-9,9'-spirobi[fluorene]-2,2',7,7'-tetraamine, which is about -0.07 V, and equal or less positive than 1,3-bis(carbazol-9-yl)benzene, which is about 0.93 V, when measured under the same conditions by cyclic voltametry against Fc/Fc+ in dichloromethane solution at room temperature.

In an embodiment the first oxidation potential of the first organic aromatic matrix compound is more positive than about -0.07 V and less positive than about 0.70 V when measured under the same conditions by cyclic voltametry against Fc/Fc+ in dichloromethane solution at room temperature.

In another embodiment the first oxidation potential of the first organic aromatic matrix compound is more positive than about -0.07 V and less positive than about 0.50 V when measured under the same conditions by cyclic voltametry against Fc/Fc+ in dichloromethane solution at room temperature.

The first reduction potential of the organic p-type dopant is equal to or more positive compared to 2,3,5,6-Tetrafluor-7,7,8,8-tetracyanochinodimethan, which is about 0.18 V, when measured by cyclic voltametry against Fc/Fc+ in acetonitrile at room temperature.

In an embodiment the first reduction potential of the organic p-type dopant is equal or more positive than of 2,2'-(perfluoronaphthalene-2,6-diylidene) dimalononitrile, which is about 0.25 V, when measured under the same conditions by cyclic voltametry against Fc/Fc+ in acetonitrile solution at room temperature. High conductivity of the doped layer may be achieved, when the p-type dopant is selected in this range.

A first n-type layer is provided between the second electrode and the first light absorbing layer.

The second organic aromatic matrix compound has a molecular weight of 300 to 1500.

In another embodiment the second organic aromatic matrix compound has a molecular weight of 400 to 800.

The first reduction potential of the second organic aromatic matrix compound is in the range of ± 1.00 V compared to the reduction potential of C60, which is about -1.00 V, when measured under the same conditions by cyclic voltametry against Fc/Fc+ in acetonitrile at room temperature.

In an embodiment the first reduction potential of the second organic aromatic matrix compound is more negative than -0.50 V and less negative than -1.50 V when measured under the same conditions by cyclic voltametry against Fc/Fc+ in acetonitrile at room temperature.

In another embodiment the first reduction potential of the second organic aromatic matrix compound is about -1.00 V when measured under the same conditions by cyclic voltametry against Fc/Fc+ in acetonitrile at room temperature.

The n-type dopant is either a molecular dopant comprising an organic compound having a molecular weight of 300 to 1500, or a metal compound selected from the group consisting of a metal halide having a molecular weight of 25 to 500, a metal complex having a molecular weight of 150 to 1500, and a zero-valent metal selected from the group consisting of alkali, alkaline earth, and rare earth metals.

In an embodiment the n-type dopant is an organic molecular dopant having a molecular weight of 300 to 1200.

In another embodiment the n-type dopant is a molecular dopant and the first oxidation potential is more negative than about -0.20 V and less negative than about -1.00 V , when measured under the same conditions by cyclic voltametry against Fc/Fc+ in dichloromethane solution at room temperature.

In a further embodiment the n-type dopant is a molecular dopant and the first oxidation potential is more negative than about -0.40 V and less negative than about -0.70 V , when measured under the same conditions by cyclic voltametry against Fc/Fc+ in dichloromethane solution at room temperature.

In a further embodiment the n-type dopant is a metal compound selected from the group of metal halide having a molecular weight of 25 to 250.

In a further embodiment the n-type dopant is a metal complex having a molecular weight of 150 to 1000.

In another embodiment the n-type dopant may be one of an alkali halide, and a metal complex selected from the group of alkali metal organic complex and main group and transition metal paddle-wheel complexes.

In a further embodiment the n-type dopant is a zero-valent metal selected from the group of Li, Na, K, Rb, Cs, Mg, Ca, Sr, Ba, Eu, Yb and Sm.

In another embodiment the n-type dopant is a zero-valent metal selected from the group of Li, Mg, Eu, Yb and Sm.

The light absorbing layer according to the disclosure comprises at least one absorber compound. The absorber compound may have a stoichiometry of AMX₃ or A₂MX₄, where "A" and "M" are cations and "X" is an anion. The "A" and "M" cations can have a variety of charges and in the original Perovskite mineral (CaTiO₃), the A cation is divalent and the M cation is tetravalent. The term "perovskite" as used here refers to the "perovskite crystal structure", but not limited to the specific structure of the perovskite material, CaTiO₃. "Perovskite" may encompass any material that has the same type of crystal structure as calcium titanium oxide, and materials in which the bivalent cation is replaced by two separate monovalent cations. The perovskite formulae as used here may include structures having three or four anions, which may be the same or different, and/or one or two organic cations, and / or metal atoms carrying two or three positive charges. Organic-inorganic perovskites are hybrid materials exhibiting combined properties of organic composites and inorganic crystallinity. The inorganic component forms a framework bound by covalent and ionic interactions, which provide high carrier mobility. The organic component helps in the self-assembly process of those materials. It also enables the hybrid materials to be deposited by low-cost technique as other organic materials. Additional important property of the organic component is to tailor the electronic properties of the organic-inorganic material by reducing its dimensionality and the electronic coupling between the inorganic sheets.

In another embodiment, A is a monovalent or bivalent cation. In another embodiment, A is selected from the group of monovalent or bivalent ammonium cations and alkali metal cations and alkaline earth metal cations.

In a further embodiment A is independently selected from organic, monovalent cations selected from primary, secondary, tertiary or quaternary organic ammonium compounds, including N-containing heteroaryl rings and ring systems, A having from 1 to 60 carbons and 1 to 20 heteroatoms; or being an organic, bivalent cation selected from primary, secondary, tertiary or quaternary organic ammonium compounds having from 1 to 60 carbons and 2 to 20 heteroatoms and having two positively charged nitrogen atoms; or being selected from the group of alkaline metals and/or alkaline earth metals.

In another embodiment A is the methyl ammonium (MA) cation [(CH₃)₃N]⁺ or alkali metal cation or a combination thereof.

In an embodiment, M is a divalent metal cation or a trivalent metal cation. In another embodiment, M is a divalent metal cation selected from the group consisting of Cu²⁺, Ni²⁺, Co²⁺, Fe²⁺, Mn²⁺, Cr²⁺, Pd²⁺, Cd²⁺, Ge²⁺, Sn²⁺, Pb²⁺, Eu²⁺, or Yb²⁺ or a trivalent metal cation selected from the group consisting of Bi³⁺ and Sb³⁺. In still a further embodiment, M is selected from the group consisting of Pd²⁺, Sn²⁺.

In an embodiment X is a monovalent anion. In another embodiment X is independently selected from Cl⁻, Br⁻, I⁻, NCS⁻, CN⁻, and NCO⁻. In a further embodiment, X is selected from I⁻, Cl⁻, and Br⁻.The at least one stack of layers comprises a first undoped organic performance enhancement layer arranged between the organic n-type layer and the first light absorbing layer. A second undoped organic performance enhancement layer may be arranged between the organic p-type layer and the first light absorbing layer. The undoped organic performance enhancement layer may comprise at least one of the first and the second organic matrix compound. The undoped organic performance enhancement layer does neither contain an organic p-type dopant nor an n-type dopant.

In another embodiment the second undoped organic performance enhancement layer is in direct contact with the first organic p-type layer and with the first light absorbing layer.

In an embodiment the second undoped organic performance enhancement layer comprises the first organic aromatic matrix compound.

In another embodiment the second undoped organic performance enhancement layer is in direct contact with the second organic p-type layer and with the first light absorbing layer.

In a further embodiment the first undoped organic performance enhancement layer comprises the second organic aromatic matrix compound.

The solar cell may further comprise at least one of a second n-type layer provided between the first electrode and the at least one stack of layers; and a second organic p-type layer provided between the at least one stack of layers and the second electrode. The second n-type layer may be equal to or different from the first n-type layer. The second organic p-type layer may be equal to or different from the first organic p-type layer. With regard to different layer design, one or more of the parameters provided for the layers may be different for the first and second layer.

In an embodiment the second n-type layer is in direct contact with the first electrode and with the at least one stack of layers.

In another embodiment the second organic p-type layer is in direct contact with the second electrode and with the at least one stack of layers.

The solar cell may further comprise a second light absorbing layer arranged between the first stack of layers and one of the first and the second electrode.

In an embodiment the second light absorbing layer is a solar cell.

In another embodiment the second light absorbing layer comprises a light absorbing layer selected from the group of silicon (Si), copper-indium-gallium-diselenide (CIDS), cadmium-telluride (CdTe) and an organic light absorbing layer.

In a further embodiment the second light absorbing layer is in direct contact with the first stack of layers and one of the first or the second electrode.

The solar cell may comprise at least two stacks of layers arranged between the first and the second electrode. The at least two stacks of layers may be provided in direct contact.

In an embodiment at least one undoped interlayer may be arranged between neighboring stacks of layers.

The first organic aromatic matrix compound may be selected from the group consisting of triarylamine, carbazole, thiophene, phthalocyanine, diphenylhydrazone, and quinoxaline. The second organic aromatic matrix compound may be selected from the group consisting of acridine, benzoacridine, dibenzoacridine, anthracene, pyrene, triazine, and xanthene.

In an embodiment the first oxidation potential of the n-type dopant may be equal or less positive than (1,3-dicyclohexyl-4,5-dimethyl-1H-imidazol-3-ium-2-yl)triphenylborate, which is 0.89 V, when measured under the same conditions by cyclic voltametry against Fc/Fc⁺ in dichloromethane solution at room temperature.

The organic p-type dopant may be provided with a concentration of 3 wt% to 50 wt% in the organic p-type layer.

In an embodiment the organic p-type dopant may be provided with a concentration of 5 wt% to 15 wt%.

The n-type dopant in the n-type layer may be provided with a concentration, in case of a molecular dopant, of 3 wt% to 60 wt%. In case of a metal dopant, in the n-type layer, the n-type dopant may be provided with a concentration 0.5 mol% to 10 mol%.

In an embodiment the molecular n-type dopant in the n-type layer may be provided with a concentration of 15 wt% to 45 wt%.

In the at least one stack of layers, at least one of the following may be provided: the organic p-type layer is having a layer thickness of 25 nm to 1000 nm. In an embodiment the organic p-type layer is having a thickness of 30 to 500nm. In another embodiment the organic p-type layer is having a thickness of 30 to 150 nm.

The n-type layer is having a layer thickness of 25 nm to 1000 nm. In an embodiment the n-type layer is having a thickness of 30 nm to 500 nm. In another embodiment the n-type layer is having a thickness of 30 to 150 nm.

In a further embodiment the undoped organic performance enhancement layer is having a thickness of 5 nm to 30 nm.

A method to determine the ionization potentials (IP) is the ultraviolet photo spectroscopy (UPS). It is usual to measure the ionization potential for solid state materials; however, it is also possible to measure the IP in the gas phase. Both values are differentiated by their solid state effects, which are, for example the polarization energy of the holes that are created during the photo ionization process. A typical value for the polarization energy is approximately 1 eV, but larger discrepancies of the values can also occur. The IP is related to onset of the photoemission spectra in the region of the large kinetic energy of the photoelectrons, i.e. the energy of the most weakly bounded electrons. A related method to UPS, the inverted photo electron spectroscopy (IPES) can be used to determine the electron affinity (EA). However, this method is less common. Electrochemical measurements in solution are an alternative to the determination of solid state oxidation (Eₒₓ) and reduction (E_{red}) potential. An adequate method is, for example, cyclic voltametry. To avoid confusion, the claimed energy levels are defined in terms of comparison with reference compounds having well defined redox potentials in cyclic voltametry, when measured by a standardized procedure. A simple rule is very often used for the conversion of redox potentials into electron affinities and ionization potential: IP (in eV) = 4.8 eV + e^{∗}Eₒₓ (wherein Eₒₓ is given in volts vs. ferrocenium/ferrocene (Fc⁺/Fc)) and EA (in eV) = 4.8 eV + e^{∗}E_{red} (E_{red} is given in volts vs. Fc⁺/Fc) respectively (see B.W. D'Andrade, Org. Electron. 6, 11-20 (2005)), e^{∗} is the elemental charge. Conversion factors for recalculation of the electrochemical potentials in the case other reference electrodes or other reference redox pairs are known (see A.J. Bard, L.R. Faulkner, "Electrochemical Methods: Fundamentals and Applications", Wiley, 2. Ausgabe 2000). The information about the influence of the solution used can be found in N.G. Connelly et al., Chem. Rev. 96, 877 (1996). It is usual, even if not exactly correct, to use the terms "energy of the HOMO" E(_{HOMO}) and "energy of the LUMO" E(_{LUMO}), respectively, as synonyms for the ionization energy and electron affinity (Koopmans Theorem). It has to be taken into consideration that the ionization potentials and the electron affinities are usually reported in such a way that a larger value represents a stronger binding of a released or of an absorbed electron, respectively. The energy scale of the frontier molecular orbitals (HOMO, LUMO) is opposed to this. Therefore, in a rough approximation, the following equations are valid: IP = -E(_{HOMO}) and EA = E(_{LUMO}) (the zero energy is assigned to the vacuum).

In the context of the present disclosure, the term "doped" refers to a dopant which increases electrical conductivity of the doped layer. The p-type dopant and n-type dopant of the present disclosure are essentially non-emissive dopants. The term "essentially non-emissive" means that the contribution of the non-light-emitting dopant to the emission spectrum from the device is less than 10 %, preferably less than 5 % relative to the emission spectrum.

In another aspect, the term "doped" may refer to electrical doping. An effect of "electrical doping" is an increase of the conductivity through the presence of the dopant in the layer.

The solar cell may be a p-i-n device or a n-i-p device. The terms "p-i-n" and "n-i-p" describe the layer sequence in the at least one stack of layers. In p-i-n device the deposition of the layer sequence of the at least one stack of layers begins with the p-type layer 110 followed by the light absorbing layer 100 followed by the n-type layer 130. In n-i-p device the deposition of layer sequence of the at least one stack of layers begins with the n-type layer 130 followed by the light absorbing layer 100 followed by the n-type layer 110. A common expert term for light absorbing layer is also "intrinsic layer". The term "p-i-n" arises from the sequence p-type layer/intrinsic layer/n-type layer. The term "n-i-p" arises from the sequence n-type layer/intrinsic layer/p-type layer.

In an embodiment the first electrode of the p-i-n solar cell device is transparent and illumination of the solar cell is done through the first electrode and the p-type layer. In another embodiment the second electrode of the n-i-n solar cell device is transparent and illumination of the solar cell is done through the second electrode and the n-type layer.

In a further embodiment the transparent electrode material is a thin conductive oxide (TCO).

In another embodiment the transparent electrode material is selected from the group of indium-tin-oxide (ITO), aluminum-zinc-oxide (AZO), indium-gallium-zinc-oxide (IGZO), indium-zink-oxide (IZO), molybdenum-zink-oxide (MZO) and indium-molybdenum-oxide (IMO).

In another embodiment the transparent electrode material is selected from the group of magnesium (Mg), aluminum (Al), aluminum-lithium (Al-Li), calcium (Ca), magnesium-indium (Mg-In), magnesium-silver (Mg-Ag), silver (Ag), gold (Au), or the like.

In an embodiment the first electrode is the cathode and the second electrode is the anode.

In the present specification the following terms are defined shall be applied unless a different definition is given in the claims or elsewhere in this specification.

In the context of the present specification the term "room temperature" refers to a temperature of about 20 to about 25 °C, preferably of about 22 °C.

Cyclic Voltametry (CV) is an electrochemical technique which measures the current that develops in an electrochemical cell under conditions where voltage is in excess of that voltage predicted by the Nernst equation for a given compound. CV is performed by cycling the potential of a working electrode, and measuring the resulting current.

Cyclic voltametry is used to determine the first oxidation potential and the first reduction potential.

The first oxidation potential is the potential at which the investigated compound looses one electron.

The first reduction potential is the potential at which the investigated compound gains one electron.

In an embodiment the first organic matrix compound is TaTm (N4,N4,N4",N4"-tetra([1,1'-biphenyl]-4-yl)-[1,1':4',1"-terphenyl]-4,4"-diamine) and the first oxidation potential is 0.40 V when measured under the same conditions by cyclic voltametry against Fc/Fc+ in dichloromethane solution at room temperature.

In an embodiment the first organic matrix compound is TaDi (N3,N3'-di([1,1'-biphenyl]-4-yl)-N3,N3'-dimesityl-[1,1'-biphenyl]-3,3'-diamine) and the first oxidation potential is 0.49 V when measured under the same conditions by cyclic voltametry against Fc/Fc+ in dichloromethane solution at room temperature.

In an embodiment the second organic matrix compound is C₆₀ and the first reduction potential is about -1.00 V when measured under the same conditions by cyclic voltametry against Fc/Fc+ in acetonitrile solution at room temperature.

In an embodiment the organic p-type dopant is F6-TCNNQ and the first reduction potential is about 0.25 V when measured under the same conditions by cyclic voltametry against Fc/Fc+ in acetonitrile solution at room temperature.

In another embodiment the organic p-type dopant is CyTa (2,2',2"-(cyclopropane-1,2,3-triylidene)tris(2-(p-cyanotetrafluorophenyl)acetonitrile)) and the first reduction potential is about 0.25 V when measured under the same conditions by cyclic voltametry against Fc/Fc+ in acetonitrile solution at room temperature.

In an embodiment the n-type dopant is the organic n-type dopant Phlm (N1,N4-bis(tri-p-tolylphosphoranylidene)benzene-1,4-diamine) and the first oxidation potential is about -0.46 V when measured under the same conditions by cyclic voltametry against Fc/Fc+ in dichloromethane solution at room temperature.

In an embodiment the light absorbing layer comprises an absorber compound of the formula CH₃NH₃PbI₃. This absorber compound is having a first oxidation potential comparable to the oxidation potential of TaTm when measured under the same conditions by cyclic voltametry against Fc/Fc+ in dichloromethane solution at room temperature.

As used herein, "wt%" stands for weight percentage and refers to a composition of matrix compound and dopant. It specifies the concentration of the dopant as a fraction of the total weight of the composition of matrix compound and dopant.

As used herein, "mol%" stands for molar percentage and refers to a composition of matrix compound and dopant. It specifies the number of moles of the dopant as a fraction of the total number of moles in the composition of matrix compound and dopant.

All numeric values are herein assumed to be prefixed by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "does not contain" does not include impurities. Impurities have no technical effect with respect to the object achieved by the present disclosure.

The term "molecular weight" is a physical property defined as the mass of a given substance (chemical element or chemical compound) divided by the molar amount of substance (number of mols). The base SI unit for molecular weight is kg/mol. For historical reasons, molecular weights are almost always expressed in g/mol. The molecular weight may be calculated from standard atomic masses. It is the sum of all standard atomic masses in a compound. The standard atomic masses are given in the periodic table of elements. Experimentally, the molecular weight may be determined by mass spectrometry, from the vapour density, freezing-point depression or boiling point elevation.

In the context that the undoped organic performance enhancement layers and do not contain a dopant specifies that no dopant has been added deliberately to the layer composition.

According to another aspect of the present disclosure, there is provided a method of manufacturing a solar cell, the method using deposition via vacuum thermal evaporation.

It was surprisingly found that the solar cell according to at least one aspect of the present disclosure solves the problem underlying the present disclosure by being superior over the solar cells known in the art, in particular with respect to initial performance and lifetime. The inventors have surprisingly found that particular good performance can be achieved when using, for example, a p-type layer between the first electrode and the first light absorbing layer and using an n-type layer between the second electrode and the first light absorbing layer.

### Description of embodiments

Following, further aspects are disclosed by referring to Figures. In the figures show:
- Fig. 1: a schematic representation of a solar cell in p-i-n (Fig. 1a) and n-i-p (Fig. 1b) layer sequence;
- Fig. 2: a schematic representation of a reference solar cell;
- Fig. 3: a schematic representation of a solar cell provided with a p-doped first matrix layer and n-doped second matrix layer;
- Fig. 4: a schematic representation of a solar cell provided with a p-doped layer and an n-dopant layer;
- Fig. 5: a schematic representation of a solar cell provided with a p-doped p-matrix layer and an n-doped n-matrix layer;
- Fig. 6: a schematic representation of a solar cell provided with undoped organic performance enhancement layers;
- Fig. 7: a schematic representation of a solar cell provided with an n-type layer and a p-type layer on both sides of a light absorbing layer;
- Fig. 8: a schematic representation of a solar cell provided with a second light absorbing layer;
- Fig. 9: a schematic representation of a solar cell provided with a first and a second stack of layers;
- Fig. 10: a schematic representation of a solar cell provided with more than two stacks of layers;
- Fig. 11: a schematic representation of a solar cell with a plurality of stacks of layers wherein between neighbouring stacks of layers an interlayer is provided;
- Fig. 12: a graphical representation of the current density (J) vs. voltage for the best-performing p-i-n and n-i-p solar cells;
- Fig. 13: a graphical representation of the effect of leaving out the performance enhancement layer on lifetime of the solar cell represented as open circuit voltage (Voc) vs operating time (Time);
- Fig. 14: a graphical representation of the effect of variation in organic p-type dopant concentration on lifetime of the solar cell represented as power conversion efficiency (PCE) vs operating time (Time); and
- Fig. 15: a graphical representation of the effect of variation in n-type dopant concentration on on lifetime of the solar cell represented as power conversion efficiency (PCE) vs operating time (Time)

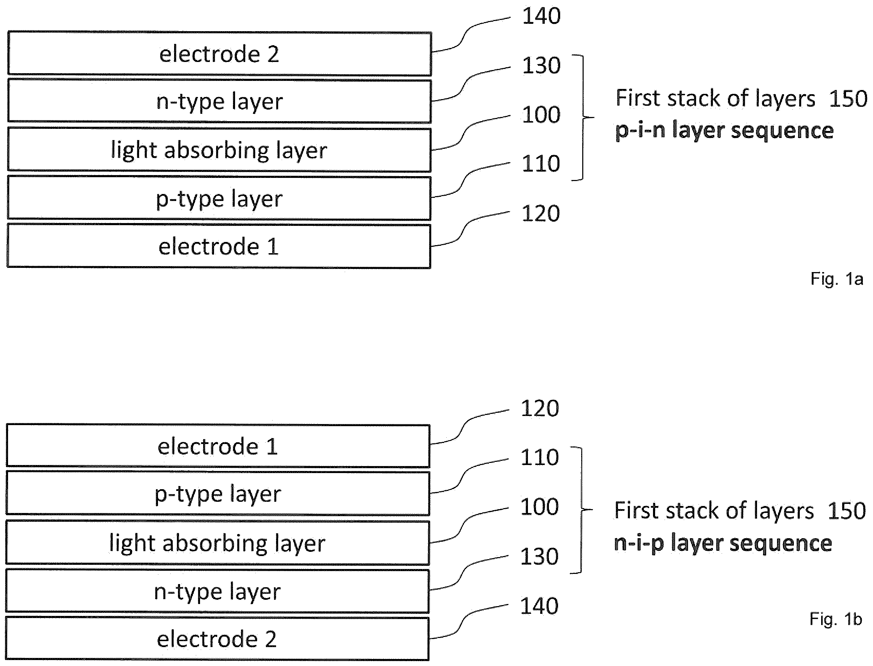

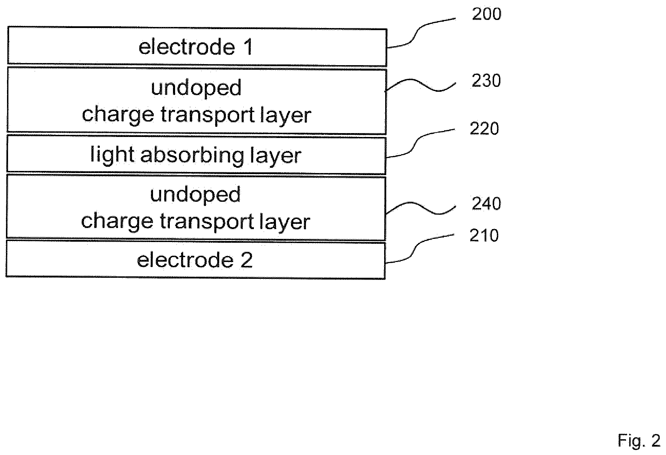

Following, alternative embodiments for a solar cell are described with reference to Fig. 1 to 12. Fig. 2 shows a schematic representation of a reference solar cell.

Referring to Fig. 1, 3 to 11, the solar cell is provided with a first and a second electrode 120, 140. Between the first and the second electrode 120, 140 a light absorbing layer 100 is provided. The light absorbing layer comprises an absorber compound provided with a perovskite crystal structure. The absorber compound may have a stoichiometry of AMX₃, where "A" and "M" are cations and "X" is an anion. By the first and second electrode 120, 140 an anode and a cathode are implemented, thereby, a n-i-p device and a p-i-n device may be provided.

The reference solar cell shown in Fig. 2 is provided with a first and a second electrode 200, 210, and a light absorbing layer 220 sandwiched between the first and the second electrode 200, 210. By the electrodes 200, 210 an anode and a cathode are implemented. Between the light absorbing layer 220 and the first and second electrode 200, 210 electrically undoped charge transport layers 230, 240 are arranged.

Fig. 1 shows a schematic representation of a solar cell wherein between the first and the second electrode 120, 140, in addition to the light absorbing layer 100, a p-type layer 110 and an n-type layer 130 are provided. The light absorbing layer 100, the p-type layer 110, and the n-type layer 130 are provided in a stack of layers 150 which, for the embodiment shown in Fig. 1, is in direct contact with the first and the second electrode 120, 140. In p-i-n device the deposition of the layer sequence of the solar cell begins with the first electrode 120. In n-i-p device the deposition of layer sequence of the solar cell begins with the second electrode 140.

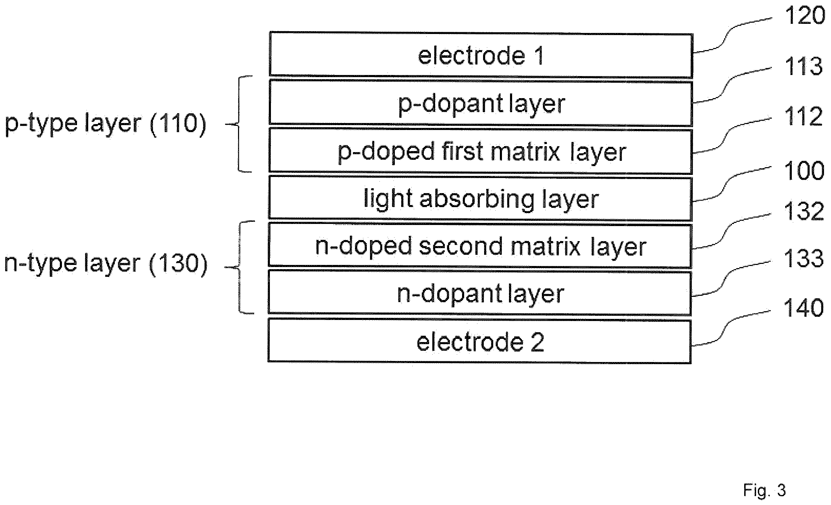

Fig. 3 shows a schematic representation of a solar cell wherein between the first and the second electrode 120, 140, in addition to the light absorbing layer 100, both the p-type layer 110 and the n-type layer 130 are provided with a two layers structure. The p-type layer 110 comprises a p-doped first matrix layer 112 and a p-dopant layer 113. The n-type layer 130 comprises an n-doped second matrix layer 132 and an n-dopant layer 133.

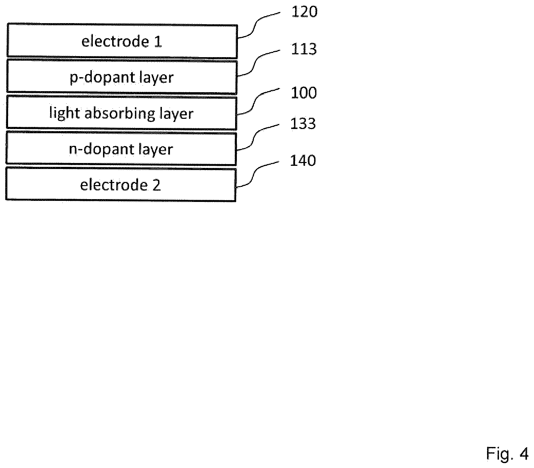

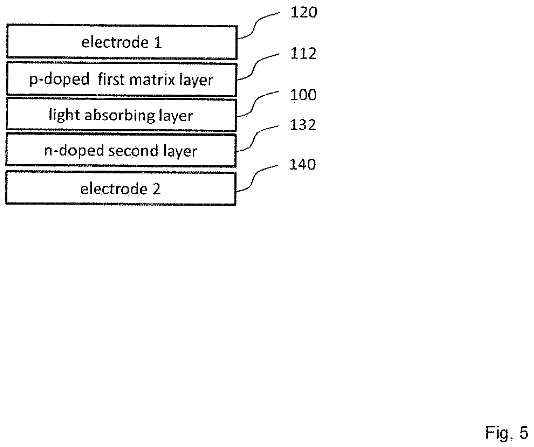

Fig. 4 shows a schematic representation of a solar cell which, compared to the solar cell in Fig. 3, is missing both the p-doped first matrix layer 112 and the n-doped second matrix layer 132. Fig. 5 shows a schematic representation of a solar cell which, compared to the solar cell in Fig. 3, is missing the p-dopant layer 113 and the n-dopant layer 133.

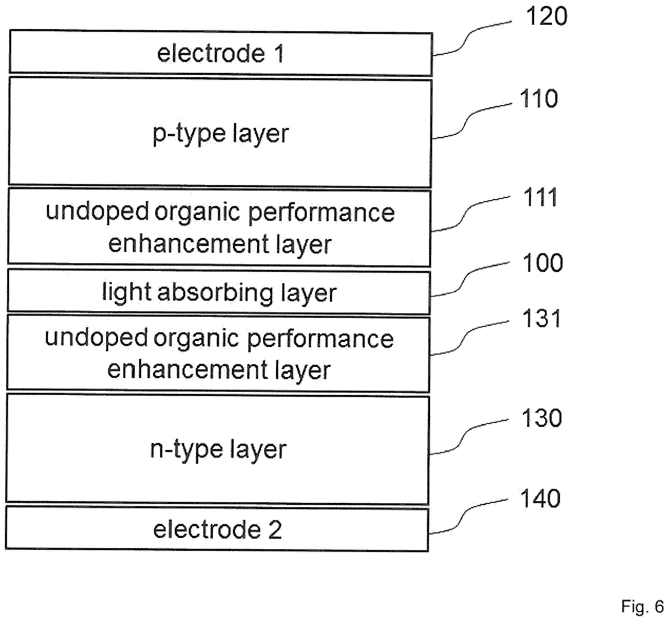

Fig. 6 shows a schematic representation of a solar cell which, compared to the solar cell in Fig. 1, comprises a first and a second electrically undoped organic performance enhancement layer 111, 131 provided on both sides of the light absorbing layer 100.

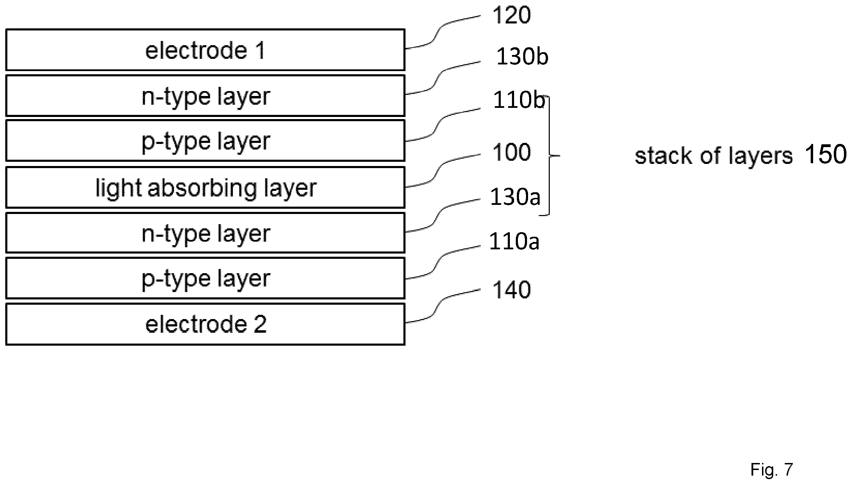

Fig. 7 shows a schematic representation of a solar cell which on both sides of the light absorbing layer 100 is provided with a combination of a p-type layer 110a, 110b and an n-type layer 130a, 130b. With regard to layer design parameters, the n-type layers 130a, 130b may be equal to each or different from each other. Similarly, the p-type layers 110a, 110b maybe equal to or different from each other regarding one or more layer design parameters.

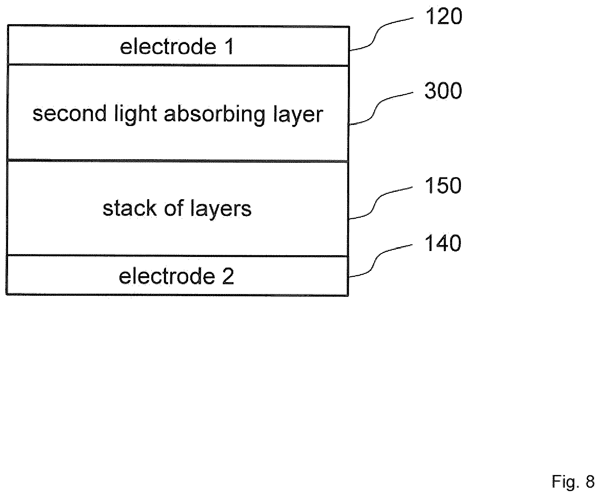

Fig. 8 shows a schematic representation of a solar cell which, compared to the solar cell in Fig. 1, is provided with a second light absorbing layer 300. In alternative embodiments the second light absorbing layer 300 may be provided between the stack of layers 150 and the second electrode 140. The second light absorbing layer may comprise inorganic absorbers selected from the group of silicon (Si), copper-indium-gallium-diselenide (CIGS), cadmium-telluride (CdTe) and organic photovoltaic layer or a combination thereof.

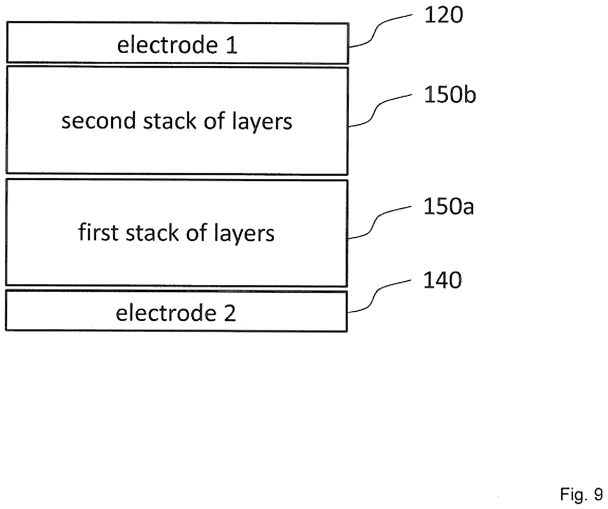

Fig. 9 shows a solar cell comprising a first and a second stack of layers 150a, 150b provided between the first and the second electrode 120, 140. The first and the second stack of layers 150a, 150b may be provided like the stack of layers 150. In an alternative embodiment, the second stack of layers 150b may be provided between the first stack of layers 150a and the second electrode 140.

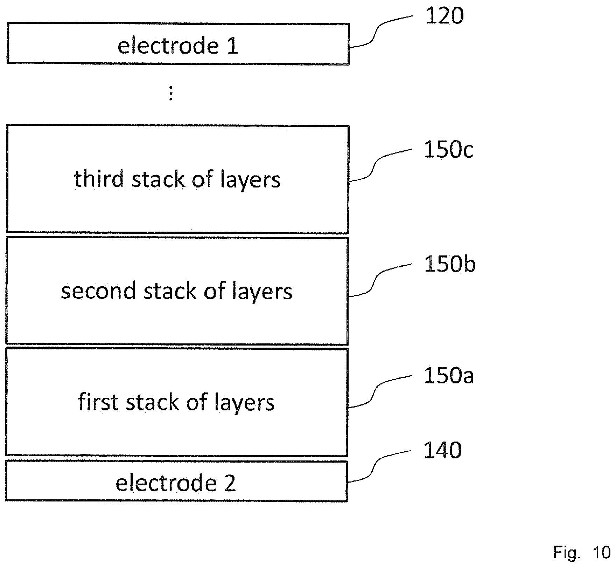

Fig. 10 shows a solar cell provided with a plurality of stacks of layers 150a, ..., 150c.

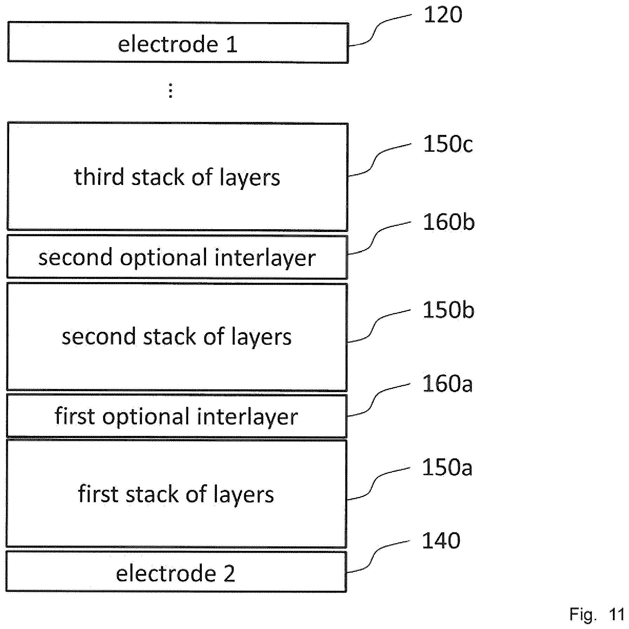

In an alternative embodiment which is shown in Fig. 11, between neighbours of the stacks of layers 150a, ..., 150c an interlayer 160a, 160b is provided.

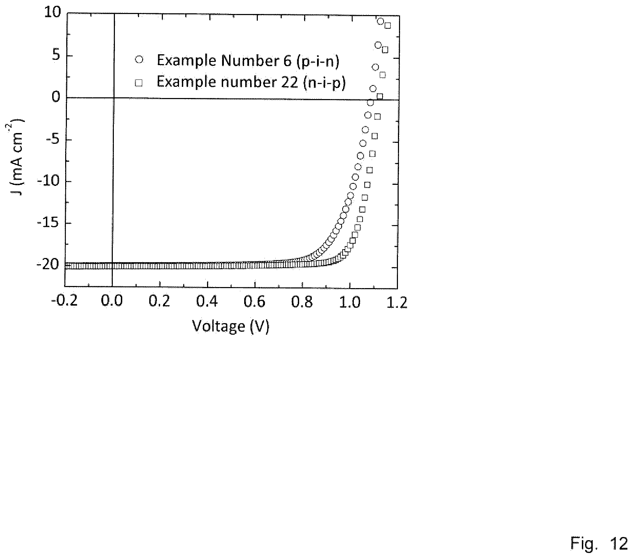

Fig. 12 shows the current density (J) vs. voltage curves of the best-performing p-i-n solar cell device (example number 6) and the best-performing n-i-p solar cell device (example number 22). Both collar cells have the same cell area of 0.01 cm².

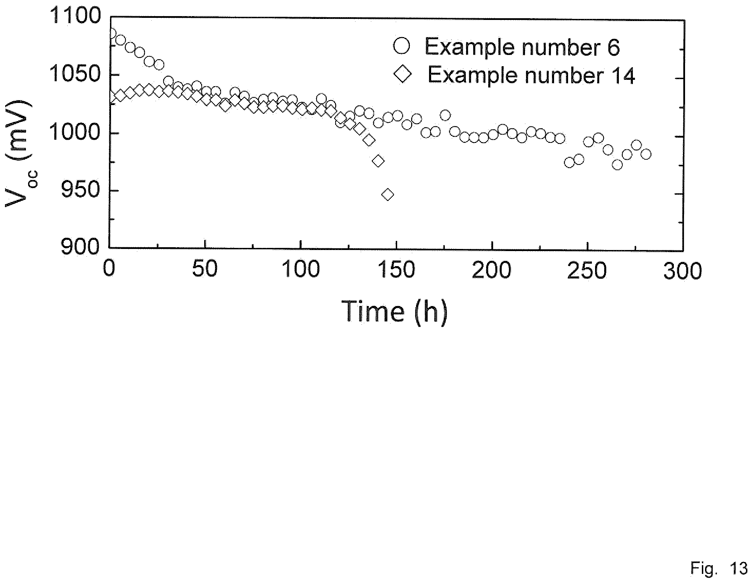

Fig. 13 shows the lifetime of a p-i-n solar cell device represented as open circuit voltage (Voc) vs operating time (Time). It is evident that the solar cell with performance enhancement layer has stable Voc. The solar cell without the performance enhancement layer shows a significant drop in Voc after 100 hours.

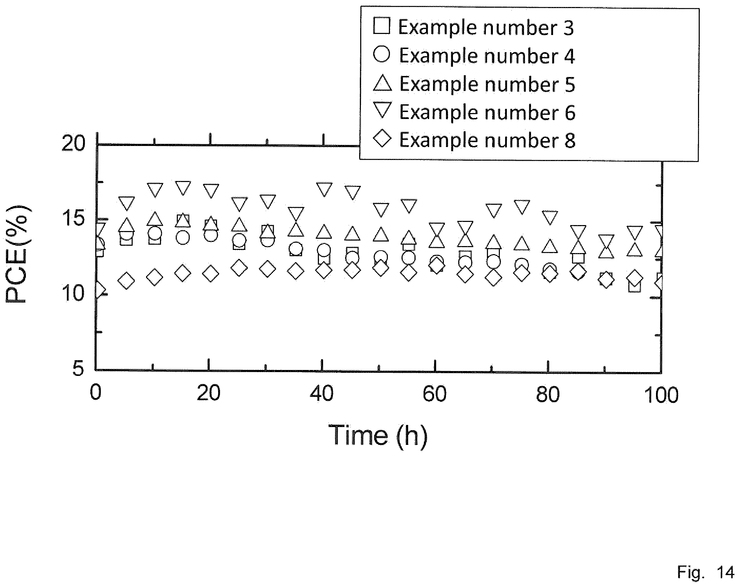

Fig. 14 shows lifetime of a p-i-n solar cell device represented as power conversion efficiency (PCE) vs operating time (Time). The PCE vs Time is stable for p-type dopant concentrations above 6 mol%.

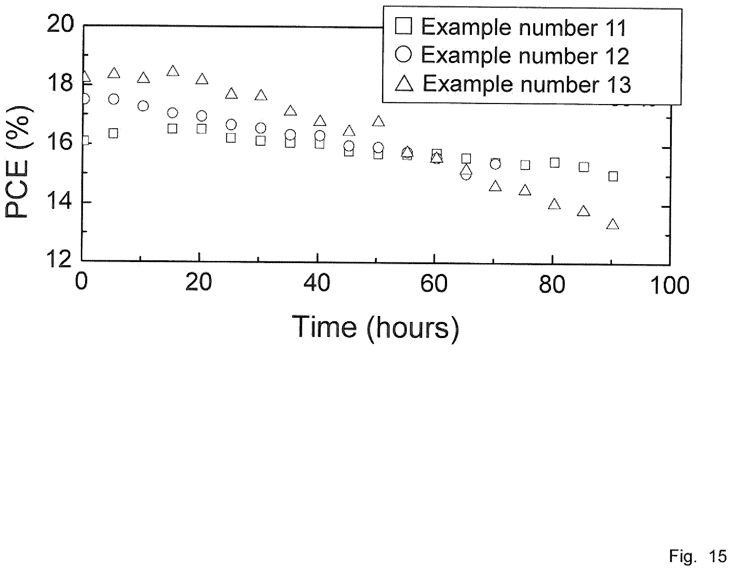

Fig. 15 shows lifetime of a p-i-n solar cell device represented as power conversion efficiency (PCE) vs operating time (Time). The PCE vs Time is most stable for n-type dopant concentrations of 30 mol%.

Following, experimental results with regard to the different embodiments of the solar cell shown in the figures are described.

Patterned ITO coated glass substrates are patterned by photolithography. Materials used are: p-type dopant 2,2'-(Perfluoronaphthalene-2,6-diylidene) dimalononitrile (F6-TCNNQ), first matrix compound N4,N4,N4",N4"-tetra([1,1'-biphenyl]-4-yl)-[1,1':4',1"-terphenyl]-4,4"-diamine (TaTm) and n-type dopant N1,N4-bis(tri-p-tolylphosphoranylidene)benzene-1,4-diamine (PhIm). The second matrix compound is fullerene (C60). The precursor materials for the perovskite light absorbing layer are PbI₂ and CH₃NH₃I (MAI).

With regard to characterization of the embodiments prepared, grazing incident X-ray diffraction (GIXRD) pattern are collected at room temperature on an Empyrean PANanalytical powder diffractometer using the Cu Kα1 radiation. Typically, three consecutive measurements are collected and averaged into single spectra. The surface morphology of the thin films is analyzed using atomic force microscopy (AFM, Multimode SPM, Veeco, USA). Scanning Electron Microscopy (SEM) images is performed on a Hitachi S-4800 microscope operating at an accelerating voltage of 2 kV over Platinum - metallized samples. Absorption spectra are collected using a fiber optics based Avantes Avaspec2048 Spectrometer.

Characterization of the solar cells is performed as follows: The external quantum efficiency (EQE) is estimated using the cell response at different wavelength (measured with a white light halogen lamp in combination with band-pass filters), where the solar spectrum mismatch is corrected using a calibrated Silicon reference cell (MiniSun simulator by ECN, the Netherlands).

The current density-voltage (J-V) characteristics are obtained using a Keithley 2400 source measure unit and under white light illumination, and the short circuit current density is corrected taking into account the device EQE. The electrical characterization was validated using a solar simulator by Abet Technologies (Model 10500 with an AM1.5G xenon lamp as the light source). Before each measurement, the exact light intensity is determined using a calibrated Si reference diode equipped with an infrared cut-off filter (KG-3, Schott). The J-V curves are recorded between -0.2 and 1.2 V with 0.01V steps, integrating the signal for 20 ms after a 10 ms delay. This corresponds to a speed of about 0.3 V s⁻¹.

Different device layouts are used for the solar cells configurations: (1) four equal areas (0.0653 cm², defined as the overlap between the ITO and the top metal contact) and measured through a shadow masks with 0.01 cm² aperture, and (2) increasing areas (0.0897 cm², 0.1522 cm², 0.3541 cm² and 0.9524 cm²) which is characterized by using a shadow mask with aperture areas of 0.0484 cm², 0.1024 cm², 0.2704 cm² and 0.8464 cm², respectively. For hysteresis study, different scan rates (0.1, 0.5 and 1 Vs⁻¹) are used, biasing the device from - 0.2 to 1.2 V with 0.01 V steps and vice versa. Light intensity dependence measurements are done by placing 0.1, 1, 10, 20, 50% neutral density filters (LOT-QuantumDesign GmbH) between the light source and the device.

Further, with regard to device preparation, ITO-coated glass substrates are subsequently cleaned with soap, water and isopropanol in an ultrasonic bath, followed by UV-ozone treatment. They are transferred to a vacuum chamber integrated into a nitrogen-filled glovebox (MBraun, H₂O and O₂ < 0.1 ppm) and evacuated to a pressure of 1·10⁻⁶ mbar. The vacuum chamber is equipped with six temperature controlled evaporation sources (Creaphys) fitted with ceramic crucibles. The sources are directed upwards with an angle of approximately 90° with respect to the bottom of the evaporator. The substrate holder to evaporation sources distance is approximately 20 cm. Three quartz crystal microbalance (QCM) sensors are used, two monitoring the deposition rate of each evaporation source and a third one close to the substrate holder monitoring the total deposition rate.

For thickness calibration, firstly the matrix compounds and the dopants (TaTm and F6-TCNNQ, C60 and PhIm) are individually sublimed. A calibration factor is obtained by comparing the thickness inferred from the QCM sensors with that measured with a mechanical profilometer (Ambios XP1). Then these materials are co-sublimed at temperatures ranging from 135-160 °C for the dopants to 250 °C for the matrix compounds, and the evaporation rate is controlled by separate QCM sensors and adjusted to obtain the desired doping concentration. In general, the deposition rate for TaTm and C60 is kept constant at 0.8 Å s⁻¹, while varying the deposition rate of the dopants during co-deposition. Undoped TaTm and C60 layers are deposited at a rate of 0.5 Å s⁻¹.

For the p-i-n configuration, 40 nm of the p-type doped first matrix layer (TaTm:F6-TCNNQ) capped with 10 nm of the pure TaTm are deposited. Once this deposition is completed, the chamber is vented with dry N₂ to replace the crucibles with those containing the precursor materials for the perovskite light absorbing layer deposition, PbI₂ and CH₃NH₃I. The vacuum chamber is evacuated again to a pressure of 10⁻⁶ mbar, and the perovskite films (light absorbing layer) are then obtained by co-deposition of the two precursors.

The calibration of the deposition rate for the CH₃NH₃I is difficult due to non-uniform layers and the soft nature of the material which impedes accurate thickness measurements. Hence, the source temperature of the CH₃NH₃I is kept constant at 70 °C and the CH₃NH₃I:PbI₂ ratio is controlled off line using grazing incident x-ray diffraction by adjusting the PbI₂ deposition temperature. The optimum deposition temperatures are 250 °C for the PbI₂ and 70 °C for the CH₃NH₃I. After deposition of a 500 nm thick perovskite film, the chamber is vented and the crucibles replaced with those containing C60 and PhIm, and evacuated again to a pressure of 10⁻⁶ mbar.

The solar cell devices are further processed by depositing a film of pure C60 and one of the n-type doped second matrix layer (C60:PhIm), with thicknesses of 10 and 40 nm, respectively. This process of exchanging crucibles is done to evaluate the effect of changes in the organic layer composition for an identical perovskite layer. In a single evaporation run five substrates (3 by 3 cm) are prepared, each substrate containing four cells. Generally, one substrate is reserved for a reference configuration allowing for evaluation of four variations in the matrix compound per perovskite evaporation. Finally the substrates are transferred to a second vacuum chamber where the metal electrode (100 nm thick) is deposited. For n-i-p devices, the same procedure as described before is used in the inverted order.

The devices prepared are listed in Table 1 (p-i-n layer sequence) and Table 2 (n-i-p layer sequence).

**Table 1. Solar cells of the p-i-n layer sequence.**

| p-i-n Layer Sequence | Device Layer Stack | Device Stack |
|---|---|---|
| p-i-n (undoped reference) | TaTm/MAPbI₃/C60 | A (not an embodiment of the invention) |
| p-i-n (two organic perfomance enhancement layers) | TaTm:F6-TCNNQ (x wt%)/TaTm/MAPbI₃/C60/C60:PhIm (30 wt%) | B p-type dopant x wt% |
| p-i-n (two organic perfomance enhancement layers) | TaTm:F6-TCNNQ (11 wt%)/TaTm/MAPbI₃/C60/C60:PhIm (x wt%) | B n-type dopant x wt% |
| p-i-n (two organic perfomance enhancement layers) | TaTm:F6-TCNNQ (11 wt%)/TaTm/MAPbI₃/C60/C60:PhIm (30 wt%) | B |
| p-i-n (no organic perfomance enhancement layer p-side) | TaTm:F6-TCNNQ (11 wt%)/MAPbI₃/C60/C60:PhIm (30 wt%) | E |
| p-i-n (no organic perfomance enhancement layer n-side) | TaTm:F6-TCNNQ (11 wt%)/TaTm/MAPbI₃/C60:PhIm (30 wt%) | F (not an embodiment of the invention) |
| p-i-n (two organic perfomance enhancement layers) | TaTm:F6-TCNNQ (11 wt%)/TaTm/MAPbI₃/C60/C60:PhIm (30 wt%) | B |
| p-i-n (no p-type layer, thin undoped layer) | TaTm (10nm) /MAPbI₃/C60/C60:PhIm (30 wt%) | G thin (not an embodiment of the invention) |
| p-i-n (no p-type layer, thick undoped layer) | TaTm(30nm)/MAPbI₃/C60/C60:PhIm (30 wt%) | G thick (not an embodiment of the invention) |
| p-i-n (no n-type layer, thin undoped layer) | TaTm:F6-TCNNQ (11 wt%)/TaTm/MAPbI₃/C60(10nm) | H thin (not an embodiment of the invention) |
| p-i-n (no n-type layer, thick undoped layer) | TaTm:F6-TCNNQ (11 wt%)/TaTm/MAPbI₃/C60(30nm) | H thick (not an embodiment of the invention) |
| p-i-n (two organic perfomance enhancement layers) | TaTm:F6-TCNNQ (11 wt%)/TaTm/MAPbI₃/C60/C60:PhIm (30 wt%) | B |
| p-i-n (n-type layer = bilayer dopant + n-type doped matrix) | TaTm:F6-TCNNQ (11 wt%)/TaTm/MAPbI₃/C60/PhIm/C60:PhIm (30 wt%) | J |
| p-i-n (n-type layer = bilayer n-type doped matrix + dopant) | TaTm:F6-TCNNQ (11 wt%)/TaTm/MAPbI₃/C60/C60:PhIm (30 wt%)/PhIm | K |

**Table 2. Solar cells of the n-i-p layer sequence.**

| n-i-p Layer Sequence | Device Layer Stack | Device Stack |
|---|---|---|
| n-i-p (two organic perfomance enhancement layers) | C60:PhIm (x wt%)/C60/MAPbI₃/TaTm/TaTm:F6-TCNNQ (11 wt%) | L n-type dopant x wt% |
| n-i-p (two organic perfomance enhancement layers) | C60:PhIm (60 wt%)/C60/MAPbI₃/TaTm/TaTm:F6-TCNNQ (11 wt%) | M |
| n-i-p (no organic perfomance enhancement layer p-side) | C60:PhIm (60 wt%)/C60/MAPbI₃/TaTm:F6-TCNNQ (11 wt%) | N |
| n-i-p (no organic perfomance enhancement layer n-side) | C60:PhIm (60 wt%)/MAPbI₃/TaTm/TaTm:F6-TCNNQ (11 wt%) | O (not an embodiment of the invention) |
| n-i-p (alternative first organic matrix compound, alternative organic p-type dopant) | C60:PhIm (30wt%)/C60/ MAPbI₃/TaDi/TaDi:CyTa (11wt%)/ | P |

For simplicity the layer sequences in the tables are written as text strings. The individual layers are separated by " / ". The compounds comprised by the layer are given in the text. For dopants the concentration is give in brackets "( )" in weight percent (wt%). The layer sequence in the solar cell device is subsequently called "stack".

The perovskite light absorbing layers are used to prepare planar diodes by sandwiching a 500 nm thick perovskite layer between organic p-type layer (hole transport or hole injection layers) and n-type layer (electron transport or electron injection layers).

In order to compare the solar cells to a reference, a device with undoped layers is chosen as a reference solar cell. This reference device with undoped charge transport layers 230, 240 is shown in Fig. 2.

For comparison of the different solar cells four parameters are selected, which are defined as follows (source: www.pveducation.org):
1) Open circuit voltage (Voc) in mV - maximum voltage available from a solar cell, and this occurs at zero current
2) Short circuit current (Jsc) in mA cm⁻² - current through the solar cell when the voltage across the solar cell is zero (i.e., when the solar cell is short circuited). This is the largest current which may be drawn from the solar cell.
3) At both of these operating points, Voc and Jsc, the power from the solar cell is zero. The "fill factor" (FF) in %, is a parameter which, in conjunction with Voc and Isc, determines the maximum power from a solar cell. The FF is defined as the ratio of the maximum power from the solar cell to the product of Voc and Isc. Graphically, the FF is a measure of the "squareness" of the solar cell and is also the area of the largest rectangle which will fit in the IV curve.
4) Power conversion efficiency (PCE) in % - ratio of energy output from the solar cell to input energy from the sun. PCE = Voc ^{∗} Jsc ^{∗} FF

The performance parameters are measured on 0.01 cm² solar cells for examples 1 to 15, on 0.0264 cm² for examples 16 to 22 and on 0.1 cm² for sample 23.

EXPERIMENT 1. The parameters of the solar cells prepared are compared to a reference solar cell not comprising any electric dopant or electrically doped layers. The architecture of such device in p-i-n layer sequence is shown in Fig. 1a. As an undoped layer the first matrix compound is used between first electrode and light absorbing layer and the second matrix compound is used between the second electrode and the light absorbing layer.

Using the architecture described above, employing single layers of undoped charge transport layers, the photovoltaic performance of the diodes under 1 sun illumination (1 sun corresponds to standard illumination at AM1.5, or 1 kW/m²) is poor, due to a pronounced s-shape of the current density (*J*) versus voltage (V) curve ( not shown). This leads to low fill factors (*FF*) and hence low PCE values (Table 3). This indicates that the extraction of the charge carrier's generated in the light absorbing layer is severely hindered.

**Table 3. Performance parameters of comparative example number 1, the undoped reference solar cell device stack A (see Fig. 2).**

| Comparative Example Number | Device Stack Abbreviation | | Jsc (mAcm⁻²) | Voc (mV) | FF (%) | PCE (%) |
|---|---|---|---|---|---|---|
| 1 | A | | 20.12 | 1041 | 16.8 | 3.5 |

The present disclosure is the insertion of p-doped and n-doped layers on either side of the light absorbing layer. These doped layers are either single layers or multiple layers. In order to study the effect of the doped layers on the solar cell device performance several device stack variations are tested in experiments 2 to 8.

EXPERIMENT 2. Variations of the concentration of the p-type dopant in the first matrix compound are performed at constant concentration of the n-type dopant of 30wt%. The optimum concentration of p-type dopant is 11 wt% (Table 4).

EXPERIMENT 3. Variations of the concentration of the n-type dopant in the second matrix compound are performed at constant concentration of the p-type dopant of 11wt%. The optimum concentration of n-type dopant is 30 wt% (Table 5).

**Table 4. Performance parameters of solar cell device stack B with different concentrations of p-type dopant.**

| Example Number | Device Stack | | Jsc (mAcm⁻²) | Voc (mV) | FF (%) | PCE (%) |
|---|---|---|---|---|---|---|
| 2 | B | 3 wt% F6-TCNNQ | 21.37 | 1053 | 56.8 | 12.78 |
| 3 | B | 5 wt% F6-TCNNQ | 20.11 | 1065 | 62.7 | 13.43 |
| 4 | B | 6 wt% F6-TCNNQ | 20.35 | 1085 | 64 | 14.13 |
| 5 | B | 9 wt% F6-TCNNQ | 19.29 | 1084 | 72.1 | 15.02 |
| 6 | B | 11 wt% F6-TCNNQ | 20.02 | 1082 | 73.5 | 15.92 |
| 7 | B | 15 wt% F6-TCNNQ | 18.88 | 1081 | 71.9 | 14.67 |
| 8 | B | 20 wt% F6-TCNNQ | 19.43 | 1084 | 72.4 | 15.25 |
| 9 | B | 40 wt% F6-TCNNQ | 19.31 | 1055 | 73.8 | 15.02 |

**Table 5. Performance parameters of solar cell device stack B with different concentrations of n-type dopant.**

| Example Number | Device Stack Abbreviation | | Jsc (mAcm⁻²) | Voc (mV) | FF (%) | PCE (%) |
|---|---|---|---|---|---|---|
| 10 | B | 15 wt% Phlm | 18.89 | 1095.04 | 68.82 | 14.23 |
| 11 | B | 30 wt% Phlm | 18.84 | 1082.41 | 72.34 | 14.75 |
| 12 | B | 45 wt% PhIm | 19.97 | 1110.1 | 66.26 | 14.68 |
| 13 | B | 60 wt% Phlm | 18.73 | 1082.97 | 68.27 | 13.84 |

**Table 6. Performance parameters of solar cell device stack B.**

| Example Number | Device Stack | | Jsc (mAcm⁻²) | Voc (mV) | FF (%) | PCE (%) |
|---|---|---|---|---|---|---|
| 6 | B | 11 wt% p-type dopant | 20.02 | 1082 | 73.5 | 15.92 |
| | | 30wt% n-type dopant | | | | |

The best performing p-i-n device stack B comprises a p-type layer containing 11wt% p-dopant and an n-type layer containing 30wt% n-type dopant and containing an undoped organic performance enhancement layer on either side of the light absorbing layer and in direct contact with the light absorbing layer (Table 6). FF and PCE are largely improved compared to the undoped reference cell device stack A, comparative example number 1.

EXPERIMENT 4. The effect of the undoped organic performance enhancement layer is tested. The undoped organic performance enhancement layer is inserted between the light absorbing layer and the p-type layer and/or between the light absorbing layer and the n-type layer. Leaving out the undoped organic performance enhancement layer between the light absorbing layer and the n-type layer significantly reduces the device performance. Leaving out the undoped organic performance enhancement layer between the light absorbing layer and the p-type layer has no significant effect on the device performance (Table 7). An investigation of the lifetime of the solar cell shows that the undoped organic performance enhancement layer in example number 6 is improving the lifetime when compared to example number 15 without undoped organic performance enhancement layer (Fig. 13).

**Table 7. Performance parameters of p-i-n solar cell device stack E and F.**

| Example Number | Device Stack | | Jsc (mAcm⁻²) | Voc (mV) | FF (%) | PCE (%) |
|---|---|---|---|---|---|---|
| 14 | E | no perfomance enhancement layer p-side | 20.19 | 1033 | 73.3 | 15.3 |
| 15 | F (not an embodiment of the invention) | no perfomance enhancement layer n-side | 17.82 | 1032 | 45 | 8.3 |

EXPERIMENT 5. In solar cell device stacks G and H the effect of leaving out either the p-type layer or the n-type layer is tested. As an undoped layer the first matrix compound is used between first electrode and light absorbing layer and the second matrix compound is used between the second electrode and the light absorbing layer. The thickness of the undoped layer is 10 nm (thin) and 30 nm (thick). Table 8 shows that the solar cell performance is significantly reduced if either p-type layer or n-type layer are not used.

**Table 8. Performance parameters of p-i-n solar cell device stack G and H (thin and thick) - Device stacks G and H not being an embodiment of the invention.**

| Example Number | Device Stack | | J_{SC} (mAcm⁻²) | V_{OC} (mV) | FF (%) | PCE (%) |
|---|---|---|---|---|---|---|
| 16 | G thin | no p-type layer | 21.13 | 994 | 28 | 5.87 |
| 17 | G thick | no p-type layer | 21.25 | 1040 | 42.3 | 9.36 |
| 18 | H thin | no n-type layer | 9.14 | 942 | 43.4 | 3.73 |
| 19 | H thick | no n-type layer | 19.39 | 1116 | 54 | 11.68 |

EXPERIMENT 6. The solar cell device stack option of n-type layer consisting of a pure dopant layer as well as of a layer comprising the n-type dopant and the second matrix compound is tested in two configurations: configuration J with the n-type dopant layer inserted between the undoped organic performance enhancement layer and the layer comprising the n-type dopant and the second matrix compound and configuration K with the n-type dopant layer inserted between the layer comprising the n-type dopant and the second matrix compound and the second electrode. Table 9 shows solar cell performance data of solar cell device stacks J and K.

**Table 9. Performance parameters of p-i-n solar cell device stack J and K.**

| Example Number | Device Stack | | J_{SC} (mAcm⁻²) | V_{OC} (mV) | FF (%) | PCE (%) |
|---|---|---|---|---|---|---|
| 20 | J | | 19.55 | 1097 | 70.1 | 15.03 |
| 21 | K | | 18.6 | 1054 | 49.2 | 9.65 |

The use of the pure n-type dopant layer in configuration J shows better solar cell device performance.

EXPERIMENT 7. Solar cells in n-i-p layer sequence (Fig. 1b) are tested using the optimum concentrations of organic p-type dopant (11 wt%) and n-type dopant (30 wt%) of example 6. The performance parameters of the solar cells are shown in Table 10.

**Table 10. Comparison of performance parameters of solar cell device stack L (n-i-p layer sequence) to solar cell device stack B (p-i-n layer sequence).**

| Example Number | Device Stack | | J_{SC} (mAcm⁻²) | V_{OC} (mV) | FF (%) | PCE (%) |
|---|---|---|---|---|---|---|
| 22 | L (0.01 cm² cell area) | 11 wt% p-type dopant | 19.32 | 1108 | 81.6 | 17.46 |
| | | 30wt% n-type dopant | | | | |
| 23 | M (0.1 cm² cell area) | 11 wt% p-type dopant | 22.08 | 1141 | 80.5 | 20.30 |
| | | 30wt% n-type dopant | | | | |
| 6 | B | 11 wt% p-type dopant | 20.02 | 1082 | 73.5 | 15.92 |
| | | 30wt% n-type dopant | | | | |

The solar cell device stack L (n-i-p layer sequence) shows better FF and PCE in comparison to the solar cell device stack B (p-i-n layer sequence). The solar cell of stack M (0.1 cm² cell area) has a higher PCE compared to the solar cell of stack L (0.01 cm² cell area). The current-voltage curves of the examples number 6 and 22 are shown in Fig. 12.

EXPERIMENT 8. Solar cells in n-i-p layer sequence (Fig. 1b) are tested using the alternative first matrix compound TaDi with a first oxidation potential about 0.09 V above the first oxidation potential of the light absorbing layer. And the alternative organic p-dopant CyTa having about the same first reduction potential as F6TCNNQ. The solar cell performance very similar when using a first matrix compound which has a first oxidation potential about 0,09 V more positive than the light absorbing layer material.

**Table 11. Performance parameters of n-i-p solar cell device stack J and P.**

| Example Number | Device Stack | | J_{SC} (mAcm⁻²) | V_{OC} (mV) | FF (%) | PCE (%) |
|---|---|---|---|---|---|---|
| 22 | J | 11 wt% F6TCNNQ in TaTm | 19.32 | 1108 | 81.6 | 17.46 |
| 24 | P | 11 wt% CyTa in TaDi | 20.20 | 1070 | 76.0 | 16.30 |

In conclusion, a substantial increase in performance, lifetime and / or fill factor has been achieved over the state of the art.

In another aspect, the solar cell may be part of a larger photovoltaic device.

The features disclosed in this specification, the figures and / or the claims may be material for the realization of various embodiments, taken in isolation or in various combinations thereof.

From the foregoing detailed description and examples, it will be evident that modifications and variations can be made to the compositions and methods of the disclosure without departing from the scope of the disclosure. Therefore, it is intended that all modifications made to the disclosure without departing from the scope of the disclosure come within the scope of the appended claims.

## Claims

1. A solar cell, comprising
- a first electrode (120);
- a second electrode (140); and
- at least one stack of layers (150) provided between the first electrode (120) and the second electrode (140), the at least one stack of layers (150) comprising
- a first light absorbing layer (100) provided with a layer thickness of 200 nm to 700 nm, and comprising an absorber compound provided with a perovskite crystal structure;
- a first organic p-type layer (110) provided between the first electrode (120) and the first light absorbing layer (100), the first organic p-type layer (110) comprising at least one of
- a layer (113) comprising an organic p-type dopant; and
- a layer (112) comprising a mixture of an organic p-type dopant and a first organic aromatic matrix compound;
wherein, for the first organic p-type layer (110), the following is provided:
- the first organic aromatic matrix compound has a molecular weight of 400 to 1500;
- the organic p-type dopant has a molecular weight of 350 to 1700;
- the oxidation potential of the first organic aromatic matrix compound is equal to or less negative compared to N2,N2,N2',N2',N7,N7,N7',N7'-octakis(4-methoxyphenyl)-9,9'-spirobi[fluorene]-2,2',7,7'-tetraamine and equal or less positive than 1,3-bis(carbazol-9-yl)benzene when measured under the same conditions by cyclic voltammetry against Fc/Fc⁺ in dichloromethane solution;
and
- the reduction potential of the organic p-type dopant is equal to or more positive compared to 2,3,5,6-Tetrafluor-7,7,8,8-tetracyanochinodimethan when measured by cyclic voltammetry against Fc/Fc⁺ in acetonitrile;
- a first n-type layer (130) provided between the second electrode (140) and the first light absorbing layer (100), the first n-type layer (130) comprising at least one of
- a layer (133) comprising an n-type dopant; and
- a layer (132) comprising of a mixture of an n-type dopant and a second organic aromatic matrix compound;
wherein, for the first n-type layer (130), the following is provided:
- the second organic aromatic matrix compound has a molecular weight of 300 to 1500;
- the reduction potential of the second organic aromatic matrix compound is in the range of ± 1.0 V compared to the reduction potential of C₆₀ when measured under the same conditions by cyclic voltammetry against Fc/Fc⁺ in acetonitrile; and
- the n-type dopant is one of
- a molecular dopant comprising an organic compound having a molecular weight of 300 to 1500, and
- a metal dopant selected from the group consisting of a metal halide having a molecular weight of 25 to 500, a metal complex having a molecular weight of 150 to 1500, and a zero-valent metal selected from the group consisting of alkali metal, alkaline earth metal, and rare earth metals; and **characterized in that** the at least one stack of layers (150) further comprises a first undoped organic performance enhancement layer (131) arranged between the organic n-type layer (130) and the first light absorbing layer (100).

2. The solar cell according to claim 1, wherein the absorber compound has a stoichiometry of AMX₃ or A₂MX₄, where "A" and "M" are cations and "X" is an anion.

3. The solar cell according to claim 1 or 2, wherein the at least one stack of layers (150) further comprises a second undoped organic performance enhancement layer (111) arranged between the organic p-type layer (110) and the first light absorbing layer (100).

4. The solar cell according to any of the preceding claims, further comprising at least one of
- a second n-type layer (130) provided between the first electrode (120) and the at least one stack of layers (150); and
- a second organic p-type layer (110) provided between the at least one stack of layers (150) and the second electrode (140).

5. The solar cell according to any one of the preceding claims, further comprising a second light absorbing layer (300) arranged between the first stack of layers (150) and one of the first and the second electrode (120, 140).

6. The solar cell according to any of the preceding claims, comprising at least two stacks of layers (150a, 150b) arranged between the first and the second electrode (120, 140).

7. The solar cell according to at least one of the preceding claims, wherein the first organic aromatic matrix compound is selected from the group consisting of triarylamine, carbazole, thiophene, phthalocyanine, diphenylhydrazone, and quinoxaline.

8. The solar cell according to at least one of the preceding claims, wherein the second organic aromatic matrix compound is selected from the group consisting of acridine, benzoacridine, dibenzoacridine, anthracene, pyrene, triazine, and xanthene.

9. The solar cell according to at least one of the preceding claims, wherein the oxidation potential of the n-type dopant is equal or less positive than (1,3-dicyclohexyl-4,5-dimethyl-1H-imidazol-3-ium-2-yl)triphenylborate when measured under the same conditions by one of cyclic voltammetry against Fc/Fc⁺ in dichloromethane solution.

10. The solar cell according to at least one of the preceding claims, wherein the n-type dopant is one of an alkali halide, and a metal complex selected from the group consisting of an alkali metal organic complex and main group and transition metal paddle-wheel complexes.

11. The solar cell according to at least one of the preceding claims, wherein the organic p-type dopant is provided with a concentration of 3 wt% to 50 wt% in the organic p-type layer (110).

12. The solar cell according to at least one of the preceding claims, wherein the n-type dopant in the n-type layer (130) is provided with a concentration of
- in case of a molecular dopant, 3 wt% to 60 wt%, and
- in case of a metal dopant, 0.5 mol% to 10 mol%.

13. The solar cell according to at least one of the preceding claims, wherein in the at least one stack of layers (150) at least one of the following is provided:
- the organic p-type layer (110) is having a layer thickness of 25 nm to 1000 nm;
- the n-type layer (130) is having a layer thickness of 25 nm to 1000 nm; and
- the undoped organic performance enhancement layer is having a layer thickness of 5 nm to 30 nm.

14. The solar cell according to at least one of the preceding claims, wherein the reduction potential of the organic p-type dopant is equal or more positive compared to 2,2'-(perfluoronaphthalene-2,6-diylidene)dimalononitrile when measured by cyclic voltammetry against Fc/Fc⁺ in acetonitrile.

## Patentansprüche

1. Solarzelle, umfassend
- eine erste Elektrode (120);
- eine zweite Elektrode (140); und
- mindestens einen Stapel von Schichten (150), der zwischen der ersten Elektrode (120) und der zweiten Elektrode (140) vorgesehen ist, wobei der mindestens eine Stapel von Schichten (150) Folgendes umfasst
- eine erste lichtabsorbierende Schicht (100) mit einer Schichtdicke von 200 nm bis 700 nm, die eine Absorberverbindung mit einer Perowskit-Kristallstruktur aufweist;
- eine erste organische p-Typ-Schicht (110), die zwischen der ersten Elektrode (120) und der ersten lichtabsorbierenden Schicht (100) vorgesehen ist, wobei die erste organische p-Typ-Schicht (110) mindestens eines der folgenden Merkmale aufweist
- eine Schicht (113) mit einem organischen p-Typ-Dotierungsmittel; und
- eine Schicht (112), die eine Mischung aus einem organischen Dotierungsmittel vom p-Typ und einer ersten organischen aromatischen Matrixverbindung aufweist;
wobei für die erste organische p-Typ-Schicht (110) Folgendes vorgesehen ist:
- die erste organische aromatische Matrixverbindung hat ein Molekulargewicht von 400 bis 1500;
- das organische Dotierungsmittel vom p-Typ hat ein Molekulargewicht von 350 bis 1700;
- das Oxidationspotential der ersten organischen aromatischen Matrixverbindung ist gleich oder weniger negativ im Vergleich zu N2,N2,N2',N2',N7,N7,N7',N7'-Octakis(4-methoxyphenyl)-9,9'-spirobi[fluoren]-2, 2',7,7'-Tetraamin und gleich oder weniger positiv als 1,3-Bis(carbazol-9-yl)benzol, wenn sie unter den gleichen Bedingungen durch zyklische Voltammetrie gegen Fc/Fc⁺ in Dichlormethanlösung gemessen werden; und
- das Reduktionspotential des organischen p-Typ-Dotierungsmittels ist gleich oder positiver als das von 2,3,5,6-Tetrafluor-7,7,8,8-tetracyanochinodimethan, gemessen durch zyklische Voltammetrie gegen Fc/Fc⁺ in Acetonitril;
- eine erste n-Typ-Schicht (130), die zwischen der zweiten Elektrode (140) und der ersten lichtabsorbierenden Schicht (100) vorgesehen ist, wobei die erste n-Typ-Schicht (130) mindestens eines der folgenden Merkmale aufweist
- eine Schicht (133) mit einem Dotierungsmittel vom n-Typ; und
- eine Schicht (132), die aus einem Gemisch aus einem Dotierungsmittel vom n-Typ und einer zweiten organischen aromatischen Matrixverbindung besteht;
wobei für die erste n-Typ-Schicht (130) Folgendes vorgesehen ist:
- die zweite organische Matrixverbindung hat ein Molekulargewicht von 300 bis 1500;
- das Reduktionspotenzial der zweiten organischen aromatischen Matrixverbindung liegt im Bereich von ±1,0 V, verglichen mit dem Reduktionspotenzial von C₆₀, wenn es unter denselben Bedingungen durch zyklische Voltammetrie gegen Fc/Fc⁺ in Acetonitril gemessen wird; und
- das n-Typ-Dotierungsmittel ist eines der folgenden
ein molekulares Dotierungsmittel, das eine organische Verbindung mit einem Molekulargewicht von 300 bis 1500 aufweist, und
- einem Metalldotierstoff, ausgewählt aus der Gruppe bestehend aus einem Metallhalogenid mit einem Molekulargewicht von 25 bis 500, einem Metallkomplex mit einem Molekulargewicht von 150 bis 1500 und einem nullwertigen Metall, ausgewählt aus der Gruppe bestehend aus Alkalimetall, Erdalkalimetall und Seltenerdmetallen; und **dadurch gekennzeichnet, dass** der mindestens eine Schichtstapel (150) ferner eine erste undotierte organische Leistungssteigerungsschicht (131) aufweist, die zwischen der organische n-Typ-Schicht (130) und der ersten lichtabsorbierenden Schicht (100) angeordnet ist.

2. Solarzelle nach Anspruch 1, wobei die Absorberverbindung eine Stöchiometrie von AMX₃ oder A₂MX₄ aufweist, wobei "A" und "M" Kationen sind und "X" ein Anion ist.

3. Solarzelle nach Anspruch 1 oder 2, wobei der mindestens eine Schichtstapel (150) ferner eine zweite undotierte organische Leistungssteigerungsschicht (111) umfasst, die zwischen der organischen p-Typ-Schicht (110) und der ersten lichtabsorbierenden Schicht (100) angeordnet ist.

4. Solarzelle nach einem der vorhergehenden Ansprüche, die außerdem mindestens eines der folgenden Merkmale aufweist
- eine zweite n-Typ-Schicht (130), die zwischen der ersten Elektrode (120) und dem mindestens einen Schichtstapel (150) vorgesehen ist; und
- eine zweite organische p-Typ-Schicht (110), die zwischen dem mindestens einen Schichtstapel (150) und der zweiten Elektrode (140) vorgesehen ist.

5. Solarzelle nach einem der vorhergehenden Ansprüche, die ferner eine zweite lichtabsorbierende Schicht (300) aufweist, die zwischen dem ersten Schichtstapel (150) und der ersten oder zweiten Elektrode (120, 140) angeordnet ist.

6. Solarzelle nach einem der vorhergehenden Ansprüche, die mindestens zwei Schichtstapel (150a, 150b) aufweist, die zwischen der ersten und der zweiten Elektrode (120, 140) angeordnet sind.

7. Solarzelle nach mindestens einem der vorhergehenden Ansprüche, wobei die erste organische aromatische Matrixverbindung ausgewählt wird aus der Gruppe bestehend aus Triarylamin, Carbazol, Thiophen, Phthalocyanin, Diphenylhydrazon und Chinoxalin.

8. Solarzelle nach mindestens einem der vorhergehenden Ansprüche, wobei die zweite organische aromatische Matrixverbindung ausgewählt wird aus der Gruppe bestehend aus Acridin, Benzoacridin, Dibenzoacridin, Anthracen, Pyren, Triazin und Xanthen.

9. Solarzelle nach mindestens einem der vorhergehenden Ansprüche, wobei das Oxidationspotential des n-Typ-Dotierungsmittels gleich oder weniger positiv ist als (1,3-Dicyc-lohexyl-4,5-dimethyl-1H-imidazol-3-ium-2-yl)triphenylborat, wenn es unter denselben Bedingungen durch eine der folgenden Methoden gemessen wird: zyklische Voltammetrie gegen Fc/Fc⁺ in Dichlormethanlösung.

10. Solarzelle nach mindestens einem der vorhergehenden Ansprüche, wobei das n-Typ-Dotierungsmittel eines von einem Alkalihalogenid und einem Metallkomplex ist, der aus der Gruppe ausgewählt wird, die aus einem organischen Alkalimetallkomplex und Hauptgruppen- und Übergangsmetall-Schaufelradkomplexen besteht.

11. Solarzelle nach mindestens einem der vorhergehenden Ansprüche, wobei das organische p-Typ-Dotierungsmittel mit einer Konzentration von 3 Gew.-% bis 50 Gew.-% in der organischen Schicht (110) vom p-Typ vorgesehen ist.

12. Solarzelle nach mindestens einem der vorhergehenden Ansprüche, wobei das n-Typ-Dotierungsmittel in der n-Typ-Schicht (130) mit einer folgenden Konzentration vorgesehen ist
- im Falle eines molekularen Dotierungsmittels 3 Gew.-% bis 60 Gew.-%, und
- im Falle eines Metalldotierungsmittels 0,5 Mol-% bis 10 Mol-%.

13. Solarzelle nach mindestens einem der vorhergehenden Ansprüche, wobei in dem mindestens einen Schichtstapel (150) mindestens eines der folgenden Merkmale vorgesehen ist:
- die organische p-Typ-Schicht (110) hat eine Schichtdicke von 25 nm bis 1000 nm;
- die n-Typ-Schicht (130) weist eine Schichtdicke von 25 nm bis 1000 nm auf; und
- die undotierte organische Leistungssteigerungsschicht hat eine Schichtdicke von 5 nm bis 30 nm.

14. Solarzelle nach mindestens einem der vorhergehenden Ansprüche, wobei das Reduktionspotential des organischen Dotierungsmittels vom p-Typ im Vergleich zu 2,2'-(Perflu-ornaphthalin-2,6-diyliden)dimalononitril gleich oder positiver ist, wenn es durch zyklische Voltammetrie gegen Fc/Fc⁺ in Acetonitril gemessen wird.

## Revendications

1. Cellule solaire comprenant
- une première électrode (120) ;
- une seconde électrode (140) ; et
- au moins un empilement de couches (150) entre la première électrode (120) et la seconde électrode (140), l'au moins un empilement de couches (150) comprenant
- une première couche absorbant la lumière (100) dont l'épaisseur de couche est comprise entre 200 nm et 700 nm, et comprenant un composé absorbant doté d'une structure cristalline de pérovskite ;
- une première couche organique de type p (110) placée entre la première électrode (120) et la première couche absorbant la lumière (100), la première couche organique de type p (110) comprenant au moins une des couches suivantes
- une couche (113) comprenant un dopant organique de type p ; et
- une couche (112) comprenant un mélange d'un dopant organique de type p et d'un premier composé organique à matrice aromatique ;
dans laquelle, pour la première couche organique de type p (110), les éléments suivants sont fournis :
- le premier composé organique de la matrice aromatique a un poids moléculaire compris entre 400 et 1500 ;
- le dopant organique de type p a un poids moléculaire compris entre 350 et 1700 ;
- le potentiel d'oxydation du premier composé organique de la matrice aromatique est égal ou moins négatif que celui du N2,N2,N2',N2',N7,N7,N7',N7'-octakis(4-méthoxyphényl)-9,9'-spirobi[fluorène]-2,2',7,7'-tétraamine et égal ou moins positif que celui du 1,3-bis(carbazol-9-yl)benzène lorsqu'il est mesuré dans les mêmes conditions par voltampérométrie cyclique en fonction de Fc/Fc⁺ dans une solution de dichlorométhane ;
et
- le potentiel de réduction du dopant organique de type p est égal ou plus positif par rapport au 2,3,5,6-tétrafluor-7,7,8,8-tétracyanochinodiméthane lorsqu'il est mesuré par voltampérométrie cyclique en fonction de Fc/Fc⁺ dans l'acétonitrile ;
- une première couche de type n (130) placée entre la seconde électrode (140) et la première couche absorbant la lumière (100), la première couche de type n (130) comprenant au moins l'une des couches suivantes
- une couche (133) comprenant un dopant de type n ; et
- une couche (132) comprenant un mélange d'un dopant de type n et d'un second composé organique à matrice aromatique ;
dans laquelle, pour la première couche organique de type n (130), les éléments suivants sont fournis :
- le second composé organique de la matrice aromatique a un poids moléculaire compris entre 300 et 1500 ;
- le potentiel de réduction du second composé organique de la matrice aromatique est de l'ordre de ± 1,0 V par rapport au potentiel de réduction du C₆₀ mesuré dans les mêmes conditions par voltampérométrie cyclique en fonction de Fc/Fc⁺ dans l'acétonitrile ; et
- le dopant de type n est l'un des dopants suivants
- un dopant moléculaire comprenant un composé organique ayant un poids moléculaire compris entre 300 et 1500, et
- un dopant métallique choisi dans le groupe constitué par un halogénure métallique ayant une masse moléculaire comprise entre 25 et 500, un complexe métallique ayant une masse moléculaire comprise entre 150 et 1500, et un métal de valence zéro choisi dans le groupe constitué par les métaux alcalins, les métaux alcalino-terreux et les métaux des terres rares ; et
**caractérisée en ce que** l'au moins un empilement de couches (150) comprend en outre une première couche organique non dopée d'amélioration des performances (131) disposée entre la couche organique de type n (130) et la première couche absorbant la lumière (100).

2. Cellule solaire selon la revendication 1, dans laquelle le composé absorbant a une stoechiométrie de AMX₃ ou A₂MX₄, où « A » et « M » représentent des cations et « X » représente un anion.

3. Cellule solaire selon la revendication 1 ou la revendication 2, dans laquelle l'au moins un empilement de couches (150) comprend en outre une seconde couche organique non dopée d'amélioration des performances (111) disposée entre la couche organique de type p (110) et la première couche absorbant la lumière (100).

4. Cellule solaire selon l'une quelconque des revendications précédentes, comprenant en outre au moins l'un des éléments suivants
- une seconde couche de type n (130) placée entre la première électrode (120) et au moins un empilement de couches (150) ; et
- une seconde couche organique de type p (110) placée entre l'au moins un empilement de couches (150) et la seconde électrode (140).

5. Cellule solaire selon l'une quelconque des revendications précédentes, comprenant en outre une seconde couche absorbant la lumière (300) disposée entre le premier empilement de couches (150) et l'une de la première et de la seconde électrode (120, 140).

6. Cellule solaire selon l'une quelconque des revendications précédentes, comprenant au moins deux empilements de couches (150a, 150b) disposés entre la première et la seconde électrode (120, 140).

7. Cellule solaire selon l'une quelconque des revendications précédentes, dans laquelle le premier composé organique de la matrice aromatique est choisi dans le groupe constitué par la triarylamine, le carbazole, le thiophène, la phtalocyanine, la diphénylhydrazone et la quinoxaline.

8. Cellule solaire selon l'une quelconque des revendications précédentes, dans laquelle le second composé organique aromatique de la matrice est choisi dans le groupe constitué par l'acridine, la benzoacridine, la dibenzoacridine, l'anthracène, le pyrène, la triazine et le xanthène.

9. Cellule solaire selon l'une quelconque des revendications précédentes, dans laquelle le potentiel d'oxydation du dopant de type n est égal ou inférieur par rapport au (1,3-dicyclohexyl-4,5-diméthyl-1H-imidazol-3-ium-2-yl)triphénylborate lorsqu'il est mesuré dans les mêmes conditions par voltampérométrie cyclique sur Fc/Fe⁺ dans une solution de dichlorométhane.

10. Cellule solaire selon l'une quelconque des revendications précédentes, dans laquelle le dopant de type n est l'un des halogénures alcalins et un complexe métallique choisi dans le groupe constitué d'un complexe organique de métal alcalin et de complexes à roue à aubes de métaux du groupe principal et de métaux de transition.

11. Cellule solaire selon l'une quelconque des revendications précédentes, dans laquelle le dopant organique de type p est fourni avec une concentration allant de 3 % en poids à 50 % en poids dans la couche organique de type p (110).

12. Cellule solaire selon l'une quelconque des revendications précédentes, dans laquelle le dopant de type n dans la couche de type n (130) est fourni avec une concentration
- dans le cas d'un dopant moléculaire, de 3 % en poids à 60 % en poids, et
- dans le cas d'un dopant métallique, de 0,5 % molaire à 10 % molaire.

13. Cellule solaire selon l'une quelconque des revendications précédentes, dans laquelle dans l'au moins un empilement de couches (150), au moins l'un des éléments suivants est présent :
- la couche organique de type p (110) a une épaisseur comprise entre 25 nm et 1000 nm ;
- la couche de type n (130) a une épaisseur comprise entre 25 nm et 1000 nm ; et
- la couche organique non dopée d'amélioration des performances a une épaisseur comprise entre 5 nm et 30 nm.

14. Cellule solaire selon l'une quelconque des revendications précédentes, dans laquelle le potentiel de réduction du dopant organique de type p est égal ou plus positif par rapport au 2,2'-(perfluoronaphtalène-2,6-diylidène)dimalononitrile lorsqu'il est mesuré par voltampérométrie cyclique en fonction de Fc/Fc⁺ dans l'acétonitrile.
